(19) Europäisches Patentamt / European Patent Office / Office européen des brevets

(11) EP 2 948 780 B1

(12) EUROPEAN PATENT SPECIFICATION

(45) Date of publication and mention of the grant of the patent:
**18.09.2019 Bulletin 2019/38**

(21) Application number: **13829014.3**

(22) Date of filing: **31.12.2013**

(51) Int Cl.:
*G01R 23/17* (2006.01)   *G02F 1/11* (2006.01)
*G02F 1/125* (2006.01)

(86) International application number:
**PCT/PL2013/000177**

(87) International publication number:
**WO 2014/116128 (31.07.2014 Gazette 2014/31)**

(54) **ACOUSTO-OPTIC RF SIGNAL SPECTRUM ANALYZER**

SPEKTRUMSANALYSATOR EINES AKUSTOOPTISCHEN HF-SIGNALS

ANALYSEUR ACOUSTO-OPTIQUE DE SPECTRE DE SIGNAUX RF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.01.2013 PL 40256413**

(43) Date of publication of application:
**02.12.2015 Bulletin 2015/49**

(73) Proprietor: **Instytut Optyki Stosowanej**
**03-805 Warszawa (PL)**

(72) Inventors:
• **GALAS, Jacek**
  **PL-05-092 Lomianki (PL)**
• **CZYZEWSKI, Adam**
  **PL-00-132 Warszawa (PL)**
• **LITWIN, Dariusz**
  **PL-00-681 Warszawa (PL)**

(74) Representative: **Woznicki, Jerzy**
**ul. Nowowiejska 1/3 lok. 9**
**00-643 Warszawa (PL)**

(56) References cited:
**WO-A1-91/06014     GB-A- 2 246 459**
**US-A- 3 667 038     US-A- 3 988 671**

• **KERSEY A D: "A REVIEW OF RECENT DEVELOPMENTS IN FIBER OPTIC SENSOR TECHNOLOGY", OPTICAL FIBER TECHNOLOGY, ACADEMIC PRESS, LONDON, US, vol. 2, 13 February 1996 (1996-02-13), pages 291-317, XP002053711, ISSN: 1068-5200, DOI: 10.1006/OFTE.1996.0036**
• **KWANG JO LEE, ET AL.: "Axial strain dependence of all-fiber acousto-optic tunable filters", OPTICS EXPRESS, vol. 17, no. 4, 16 February 2009 (2009-02-16), pages 2348-2357, XP002723090,**
• **CHANG I C ED - BASS M (ED): "ACOUSTO-OPTIC DEVICES AND APPLICATIONS", 1 January 1995 (1995-01-01), HANDBOOK OF OPTICS, VOLUME II, DEVICES, MEASUREMENTS, AND PROPERTIES, MCGRAW-HILL, NEW YORK, NY, PAGE(S) 12.01 - 12.54, XP000613671, ISBN: 978-0-07-047974-6 page 12.19 - page 12.31 page 12.43 - page 12.44**
• **GOTTLIEB M ED - GOUTZOULIS A P ET AL: "Acousto-Optic Tunable Filters", 1 January 1994 (1994-01-01), DESIGN AND FABRICATION OF ACOUSTO-OPTIC DEVICES, NEW YORK, MARCEL DEKKER, US, PAGE(S) 197 - 283, XP001167203, ISBN: 978-0-8247-8930-5 figure 14 page 225, paragraph 3.3**

EP 2 948 780 B1

## Description

The subject of the invention is an acousto-optic RF signal spectrum analyzer intended for analyzing and measuring electrical signals with high carrier frequency, both impulse and constant.

For spectral analysis and the measurement of RF (Radio Frequency) signals with high carrier frequency, both impulse and constant, acousto-optic spectrum analyzers (AOAs) are used. They allow for analyzing signals within a very broad frequency band, at the level of several GHz, at a resolution of a few tens of kHz up to a few MHz. The phenomenon used in AOAs to measure an detect RF signals is the diffraction of monochromatic laser beam on a diffraction grating generated in the material as a result of acoustic wave propagation inside it. The acoustic wave excited in the material by a piezoelectric transducer generates a Bragg diffraction grating inside it. The angle of diffraction for monochromatic light on the diffraction grating generated is proportional to the v frequency of RF signal, while the intensity of diffracted light is a function of the RF signal amplitude. The analysis of RF signal spectrum frequency consists in measuring the diffraction angle for monochromatic (laser) light and the intensity of light diffracted at a specific angle. The detection of diffracted waves makes it possible to determine the frequency components of RF signal incoming to the transducer.

Two basic acousto-optic spectrum analyzers (AOAs) are known. In the first one RF signal comes to the piezoelectric transducer attached to an optical crystal, where an acoustic wave is excited. The wave inside the crystal generates a bulk Bragg diffraction grating, whose spatial frequency is proportional to the RF signal frequency. A monochromatic light beam is projected perpendicularly onto the grating. Light diffracted on the Bragg diffraction grating is focused by the lens on the multi-segment photo detector. The position of light spot on the detector is a function of RF signal v frequency, and is proportional to the signal amplitude. By knowing the intensity of light incoming to the particular cells of multi-segment detector it is possible to determine the value of frequency components for RF signal incoming to the piezoelectric transducer.

The first type of acousto-optic spectrum analyzers (AOAs) is constructed based on classic 3D optical systems. An example structure of such an analyzer describes the patent application FR2732468 (The broadband acousto-optic spectrum analyzer).

In the second type of acousto-optic spectrum analyzers (AOAs), made in the so-called planar technology, where a surface acoustic wave generated by the piezoelectric transducer stimulated by RF signal propagates on the crystal surface and generates on it a planar diffraction grating. The monochromatic light beam propagates in a planar optical fiber generated on the surface of crystal and is formed by thin-layer planar lenses generated on the surface of crystal in the optical fiber layer.

The first one of the lenses forms a flat parallel light beam propagating perpendicularly to the acoustic wave. This beam bends on the diffraction grating generated by the acoustic wave. Another lens focuses the light beams diffracted at the planar diffraction grating, on the multi-segment photo detector integrated with the optical fiber. The position of light spot on the detector is a function of frequency v of the RF signal, while the intensity of light is proportional to the signal amplitude. By knowing the intensity of light incoming to the particular cells of multi-segment detector it is possible to determine the value of particular frequency components for RF signal incoming to the piezoelectric transducer. An example structure of such an analyzer using a planar technology describes the patent application US4253060 (RF spectrum analyzer).

US3,667,038 discloses an acousto-optical RF spectrum analyser. The documents KERSEY A D: "A Review of Recent Developments in Fiber Optic Sensor Technology", XP002053711, and KWANG JO LEE, ET AL.: "Axial strain dependence of all-fiber acousto-optic tunable filters", XP002723090, concern fiber optic sensor technology and its use in practical sensors including acousto-optic sensors.

The RF acousto-optic spectrum analyzer, equipped with a source of polychromatic light, optical spectrometer with a multi-segment photo detector and an acousto-optic transducer placed in the light beam route, fitted with a piezoelectric transducer connected to the source of RF signals that generates the Bragg grating within the area of the wave propagation, according to the invention, rely on that the acousto-optic transducer comprises a short section of optical fiber, to the base of which a piezoelectric transducer is attached, while the opposite end of the short section is connected with another optical fiber section connected via a beam splitter with the first optical fiber section, to which a source of polychromatic light is attached, and the third section of optical fiber with an optical spectrometer attached, while the piezoelectric transducer is placed at the extension of the optical axis of the optical fiber second section.

Another acousto-optic RF spectrum analyzer, equipped with a source of polychromatic light, an optical spectrometer with multi-segment photo detector and an acousto-optic transducer placed in the light beam route, fitted with a piezoelectric transducer connected to the source of RF signals that generates the Bragg grating within the area of the wave propagation, according to the invention, rely on that the acousto-optic transducer is fitted with a gradient lens composed of two coaxially connected parts, the first and the second, while the piezoelectric transducer is attached to the base of the first part, while the base of the second part is connected with the second section of optical fiber connected via a beam splitter with the first optical fiber section, with the first optical fiber section, to which a source of polychromatic light is attached, and the third section of optical fiber with an optical spectrometer attached, while the piezoelectric transducer is placed at the extension of optical axis of the second section of optical fiber.

It is advantageous, if between the first and the second part of the gradient lens, a diaphragm is coaxially placed with a diameter lower than the gradient lens in the connection zone of both parts.

It is also advantageous, if between the first and the second part of the gradient lens a layer suppressing the acoustic wave generated in the first part, is placed.

The solution as proposed by the invention, uses the phenomenon of selective reflection of light with different wavelengths from bulk Bragg diffraction gratings generated by acoustic wave using the RF signal for analyzing the RF spectrum. Thanks to this, it is possible to use polychromatic light without reducing such parameters as resolution, and signal-to-noise ratio.

The invention is directed to an analyzer as described in independent claims 1 or 2. Advantageous embodiments are described in the dependent claims.

This invention is presented in the embodiment as shown in the drawing, where fig. 1 shows a schematic of an RF acousto-optic spectrum analyzer (AOA), fig. 2 presents the acousto-optic transducer composed of a piezoelectric transducer attached to the short section of optical fiber in side view, and fig. 3 the acousto-optic transducer composed of a piezoelectric transducer attached to the gradient lens.

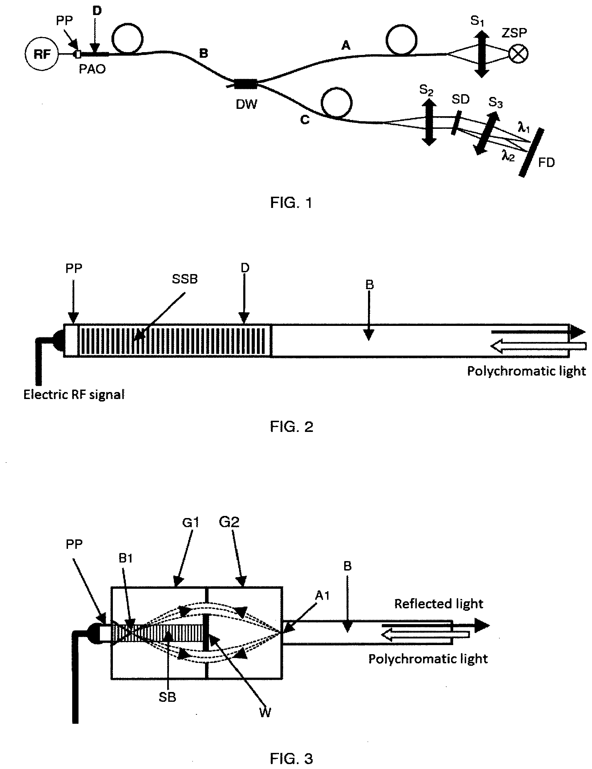

As shown in fig. 1, the RF acousto-optic spectrum analyzer (AOA) is equipped with a source of polychromatic light ZSP with its first lens $S_1$ introducing light to the first section A of optical fiber, acousto-optic transducer PAO connected with the second section B of optical fiber, beam splitter DW, and an optical spectrophotometer for analyzing light spectrum, attached to the third optical fiber section C. The sections A, B, C of the optical fiber are connected with one another through the beam splitter DW. Polychromatic light from the light source ZSP goes through the beam splitter DW to another B section of optical fiber ended with acousto-optic transducer PAO. The acousto-optical transducer PAO is composed of piezoelectric transducer PP attached to the short section D of optical fiber. This section is connected "face-to-face" with the second section B of optical fiber. Piezoelectric transducer PP excited by RF signal produces an acoustic wave within the short section D of optical fiber generating a bulk Bragg diffraction grating inside it. The light reflected from the bulk Bragg diffraction grating comes through the second optical fiber section B, beam splitter DW and the third optical fiber section C to the optical spectrometer at the acousto-optic spectrum analyzer (AOA) output. The optical spectrometer consists of an input lens S2, spectrophotometer diffraction grating SD, output lens S3 and the multi-segment photo detector FD. In the spectrophotometer optical system, the input lens S2 is a lens collimating the light outgoing from the third optical fiber section C, creating a parallel light beam falling onto the spectrophotometer diffraction grating SD. The grating diffracts light with different wavelength at different angles, while the output lens S3 focuses light with different wavelengths on the multi-segment photo detector FD, whereas each photo detector component focuses light with different wavelength λ.

As shown in fig. 2, the acousto-optic transducer PAO consists of piezoelectric transducer PP attached to the face of optical fiber short section D, where the acoustic wave can propagate. The other end of short section D is connected "face-to-face" with the second optical fiber section B. The electric RF signal supplied to the acousto-optic transducer PAO generates an acoustic wave inside it creating an optical fiber Bragg diffraction grating in the zone of its propagation that selectively reflects light at wavelength λ according to the following formula:

$$\lambda = 2n_e\Lambda$$

where $n_e$ is the effective diffraction coefficient for the material of short optical fiber section D, where light propagates, and, simultaneously, the acoustic wave, while A is the period of optical fiber diffraction Bragg grating SSB generated with the acoustic wave inside the short optical fiber section D. The acoustic wave generated in the material by RF signal with frequency ν, creating the optical fiber diffraction Bragg grating SSB with period $\Lambda_v$, reflects the light with wavelength $\lambda_v$ inside the optical fiber. The intensity of reflected light with a specific wavelength is proportional to the intensity of the corresponding RF signal frequency component. The optical spectrometer by providing the spectral analysis of light at the AOF analyzer output, simultaneously performs the RF signal spectrum analysis.

As shown in fig. 3, other acousto-optic transducer PAO consists of piezoelectric transducer PP and a double-part gradient lens composed of the first part G1, to the base of which piezoelectric transducer PP is attached, and the second part G2, to the base of which the second optical fiber section B is connected "face-to-face". Both parts G1, and G2 are coaxially connected with their internal bases. Piezoelectric transducer PP and the second optical fiber section B are situated at the extension of gradient lens optical axis. In the first part G1 of the gradient lens, the piezoelectric transducer PP generates an acoustic wave that creates bulk Bragg diffraction grating SB. The second optical fiber section B delivers a polychromatic light beam to the gradient lens. The light reflected from the bulk Bragg diffraction grating SB is transmitted by optical fibers via beam splitter DW to the optical spectrometer at the output of optic analyzer AOA.

In the acousto-optic transducer PAO, as presented in fig. 3, the polychromatic light introduced to the second optical fiber section B goes to the second part G2 of gradient lens at start point A1 located on its optical axis. From this point, light beams pass the lens through curved lines thanks to the radial changes of the light coefficient of refraction. Light with a given wavelength λ leaving the start point A1 focuses inside the second part G2 of gradient lens at final point B1 situated on the lens optical axis. Light of different wavelength will focus also on the lens axis near the point B1. The place where light beams focus on the optical axis of the lens does not affect the transducer operation. However, it is important that the focus point is located in the area of acoustic wave propagation generated by the piezoelectric transducer PP. The course of beams is marked with a dotted line. In the connection zone of two gradient lens parts, the light beams are parallel to its optical axis. After passing this zone, beams re-focus at the final point B1. At the connection zone of the first and second part G1, G2 we can place a layer suppressing the acoustic wave as well as the diaphragm W for light beams propagating in the area closest to the optical axis. Thanks to this the area of interaction between acoustic wave and the light beam has been limited to the area around the final point B1. Such a construction of acousto-optic transducer PAO makes it possible to analyze very short RF signals, because the time of their passing through the zone of interaction between acoustic wave and the light beam is very short. In the area of final point B1 occurs a selective reflection of light with a wavelength of λ depending on the RF electric signal frequency that stimulates piezoelectric transducer PP. This light will return to lens start point A1 and will be re-introduced to the optical fiber second section B, where it will be sent back to the optical spectrometer. It is important that the first part G1 of gradient lens is long enough to place the focus point for all light beams with different wavelengths inside the lens. The light reflected from the Bragg grating generated by the acoustic wave does not return to the optical fiber, instead, after passing final point B1 it reaches the walls of gradient lens, disperses and leaves the lens through its walls. This light will not disturb the measurement process, which will allow us to obtain a high signal-to-noise ratio in the device constructed according to this invention and will make it possible to minimize the errors of RF electric signal spectrum analysis.

**Claims**

1. An RF signal acousto-optic spectrum analyzer (AOA), comprising:

   a source of polychromatic light (ZSP);
   an optical spectrometer with a multi-segment photo detector (FD);
   an acousto-optic transducer (PAO) placed in the route of a light beam, and including a piezoelectric transducer (PP) connected with a source of RF signals and being configured for generating acoustic waves creating a Bragg grating (SSB) in the area of wave propagation; and
   a beam splitter (DW),

**characterized in that**:

   the acousto-optic transducer (PAO) includes a short optical fiber section (D), to the base of which the piezoelectric transducer (PP) is attached;
   the opposite end of the short optical fiber section (D) is connected with a second optical fiber section (B);
   the second optical fiber section (B) is connected via the beam splitter (DW) with a first optical fiber section (A);
   the source of polychromatic light (ZSP) is attached to the first optical fiber section (A); and
   a third optical fiber section (C) is connected to the optical spectrometer;
   the piezoelectric transducer (PP) being situated at the extension of optical axis of the second optical fiber section (B).

2. An RF signal acousto-optic spectrum analyzer AOA) according to claim 1, in which the short optical fiber section (D) is substituted by a gradient lens composed of two coaxially connected parts (G1, G2), the first and the second, while the piezoelectric transducer (PP) is attached to the base of the first part (G1), and the base of the second part (G2) is connected with the second optical fiber section (B).

3. The analyzer according to claim 2, wherein between the first part (G1) and the second part (G2) of the gradient lens there is a diaphragm (W) coaxially installed with a diameter lower than the gradient lens diameter in the connection zone of both parts.

4. The analyzer according to claim 2 or 3, wherein between the first part (G1) and the second part (G2) of the gradient lens there is a layer suppressing the acoustic wave excited in the first part (G1).

**Patentansprüche**

1. Spektrumsanalysator eines akustooptischen HF-Signals (AOA), bestehend aus:

   Quelle polychromatischen Lichts (ZSP);
   optisches Spektrometer mit Mehrsegment-Lichtdetektor (FD);
   akustooptischer Wandler (PAO) platziert auf dem Weg eines Lichtstrahls, mit einem piezoelektrischen Wandler (PP) verbunden mit der Quelle von HF-Signalen, konfiguriert zur Erzeugung einer akustischen Welle, die in ihrem Ausbreitungsbereich die Bragg-Gitter bildet (SSB); sowie ein Strahlenteiler (DW); **dadurch gekennzeichnet, dass**:

einen Bestandteil des akustooptischen Wandlers (PAO) ein kurzes Teilstück (D) von Lichtleiter bildet, an deren Unterlage der piezoelektrischer Wandler (PP) angebracht ist;

das gegenüberliegende Ende des Teilstücks (D) des Lichtleiters ist mit dem zweiten Teilstück (B) des Lichtleiters verbunden;

das zweite Teilstück (B) des Lichtleiters ist über Strahlenteiler (DW) mit dem ersten Teilstück (A) des Lichtleiters verbunden; an das erste Teilstück (A) ist die Quelle polychromatischen Lichts (ZSP) angeschlossen;

das dritte Teilstück (C) des Lichtleiters ist an das optische Spektrometer angeschlossen;

und der piezoelektrische Wandler (PP) ist an einer Verlängerung der optischen Achse des zweiten Teilstücks (B) des Lichtleiters angebracht.

**2.** Der Spektrumsanalysator eines akustooptischen HF-Signals (AOA) nach Anspruch 1, **dadurch gekennzeichnet, dass** anstatt des kurzen Teilstücks (D) des Lichtleiters eine Gradientenlinse aus zwei koaxial verbundenen Teilen (G1, G2), des ersten und des zweiten, angeschlossen ist, wobei der piezoelektrische Wandler (PP) an den ersten Teil (G1), und die Unterlage des zweiten Teils (G2) mit dem zweiten Teilstück (B) des Lichtleiters verbunden ist.

**3.** Der Spektrumsanalysator nach Anspruch 2, **dadurch gekennzeichnet, dass** zwischen dem ersten und zweiten Teil (G1, G2) der Gradientenlinse eine Blende (W) mit einem Durchmesser koaxial angebracht ist, der kleiner als der Durchmesser der Gradientenlinse ist.

**4.** Der Spektrumsanalysator nach Anspruch 2 oder 3, **dadurch gekennzeichnet, dass** zwischen dem ersten und zweiten Teil (G1, G2) der Gradientenlinse eine Dämpfschicht für die Unterdrückung der akustischen Welle angebracht ist, welche im ersten Teil (G1) erzeugt wird.

## Revendications

**1.** Analyseur acoustique-optique (AOA) de spectre de signaux RF contenant: source lumineuse polychromatique (ZSP);

un spectromètre optique avec un détecteur de lumière multi-segments (FD);

transducteur acoustique-optique (PAO) placé sur le trajet d'un faisceau lumineux, ayant un transducteur piézoélectrique (PP) connecté à une source de signal RF et configuré pour exciter une onde acoustique formant un réseau de Bragg (SSB) dans la zone de propagation des ondes; et un diviseur de faisceau (DW); **caractérisé en ce que**:

le transducteur acoustique-optique (PAO) se compose d'un court segment (D) de la fibre optique à laquelle un transducteur piézoélectrique (PP) est connecté dans sa base;

l'extrémité opposée du court segment (D) de fibre optique est reliée au deuxième segment (B) de la fibre optique;

le deuxième segment (B) de la fibre optique est relié par un diviseur de faisceau (DW) au premier segment (A) de la fibre optique; la source lumineuse polychromatique (ZSP) est reliée au premier segment (A);

le troisième segment (C) de la fibre optique est relié au spectromètre optique; et le transducteur piézoélectrique (PP) est situé sur le prolongement de l'axe optique du deuxième segment (B) de la fibre optique.

**2.** Analyseur acoustique-optique (AOA) de spectre de signaux RF selon la revendication 1, **caractérisé en ce qu'**une lentille à gradient composée de deux parties connectées coaxialement (G1, G2), première et seconde, est connectée à la place d'un court segment (D) de la fibre optique, où le transducteur piézoélectrique (PP) est connecté à la base de la première partie (G1) et la base de la deuxième partie (G2) est connectée au deuxième segment (B) de la fibre optique.

**3.** Analyseur, selon la revendication 2, **caractérisé en ce qu'**entre la première partie (G1) et la deuxième partie (G2) de la lentille à gradient, une ouverture (W) placée coaxialement d'un diamètre inférieur au diamètre de la lentille à gradient est placée dans la zone où les deux parties se connectent.

**4.** Analyseur, selon les revendications 2 ou 3, **caractérisé en ce qu'**entre entre la première partie (G1) et la deuxième partie (G2) de la lentille à gradient il y a une couche qui supprime l'onde acoustique excitée dans la première partie (G1).

FIG. 1

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2732468
- US 4253060 A
- US 3667038 A

**Non-patent literature cited in the description**

- **KERSEY A D.** *A Review of Recent Developments in Fiber Optic Sensor Technology*
- **KWANG JO LEE et al.** *Axial strain dependence of all-fiber acousto-optic tunable filters*